# EUROPEAN PATENT APPLICATION

(11) **EP 1 548 827 A1**
(43) Date of publication of application: **29.06.2005**
(21) Application number: 03029575.2
(22) Date of filing: 22.12.2003
(51) Int. Cl.: H01L 23/552, H01L 23/373, H01L 23/10

(54) **Integrated circuit package arrangement and method**

(71) Applicant: Telefonaktiebolaget LM Ericsson (publ), 164 83 Stockholm (SE)
(72) Inventor: Björneklett, Are, 72355 Västeras (SE); Olofsson, Lars-Anders, 175 43 Järfälla (SE)
(74) Representative: Asketorp, Göran

(57) **Abstract**

An IC package arrangement for combined heat dissipation and electrical shielding of a chip in an electronic apparatus. The arrangement comprises at least one IC chip (401) mounted on a module substrate (402) for arrangement on a PCB (405) and a cover (404) attachable to the at least one IC chip (401) by means of a gap filler (403). The at least one IC chip (401) and the module substrate (402) are further covered by the cover (404).
The invention also provides a method of assembling an IC package arrangement including a module, wherein at least one IC chip (401) is mounted on a module substrate (402), a cover (404) is either attached or attachable to the at least one IC chip (401) by means of a gap filler (403), and the module substrate (402) is either mountable or mounted on a PCB (405). The method further comprises the step of covering the at least one IC chip (401) and the module substrate (402) by means of the cover (404).

## Description

### TECHNICAL FIELD

The present invention relates generally to integrated circuit packages (IC packages) and more particularly to an IC package arrangement for heat dissipation and shielding of a chip in an electronic apparatus. The invention further relates to a method of assembling an IC package arrangement.

### DESCRIPTION OF RELATED ART

Microelectronic packaging includes Microelectronics, Systems and Packaging. Microelectronics typically refers to those micro devices such as ICs and/or modules comprising one or a few ICs, which form the basis of electronic products. IC is defined as a miniature or micro electronic device integrating such elements as transistors, resistors, dielectrics, and capacitors into an electrical circuit with a specific function. Systems refer to different electronic products such as communication products, entertainment products, computers etc. that depend on ICs and Packaging. Packaging can be defined as the bridge that connects ICs and systems to form electronic products.

Microelectronic packaging is divided into to separate levels, one IC level (also referred as Level 1) and one at System level (also referred as Level 2). At Level 1 microelectronic packaging involves i) interconnecting ICs and/or modules, ii) powering ICs/modules, iii) cooling ICs/modules, and iiiv) protecting ICs/modules. All these tasks at Level 1 are important since the signal communication poses a number of different problems such as electrical, mechanical, thermal, chemical and environmental problems, which may result in poor communication or no communication at all.

Microelectronic packaging also performs several tasks at Level 2. It allows all the components - whether they are active ICs such logic and memory that are pre-packaged or passive components such as resistors, capacitors, switches, and connectors - to be assembled on a system level board. The system level board, also called printed circuit board (PCB), carries and interconnects all the components with conductor wiring so as to form an interconnected system.

As described above, one important task at Level 1 is to provide the ICs and/or modules with good cooling. Modules in electronic applications are heat dissipating devices. For example, the power amplifying modules (PA-modules) used in mobile phones and terminals are heat dissipating devices that need good cooling. Heat dissipation from PA-modules in mobile phones has not been a significant problem previously. Until today the PA-module is mostly used for single slot operation in the GSM-system and thus it is active only 1/8 of the time. Increasing data rates will however require multi slots operation. For instance a 2 slots operation will result in double heat dissipation and a 4 slots operation four times higher heat dissipation. Hence, it will be very difficult to keep the PA-module within acceptable temperature limits.

Electrical problems relate to e.g. signal propagation. One approach of reducing the consequences of such problems is to protect the devices with shielding means. For instance, electrical shielding of mobile phones is currently done at the PCB level (i.e. Level 2). Relatively large metal cans are mounted onto the PCB after assembly of the components. Another known method is to cover the inside of the phone housing with a metal coating and make use of electrically conductive gaskets between the housing and the PCB. Both of these methods are costly and cumbersome from an assembly point of view.

In future mobile phones extended functionality PA-modules will include antenna switch functionality and they will therefore need an electrical shield covering the module itself in order to limit the radiation of unwanted signals from the PA-module. In other words, there is a need for electrical shielding of modules at the module level (Level 1) rather than at the PCB level (Level 2).

As electronic devices become increasingly faster and smaller, their sensitivity to ESD (Electro Static Discharge) increases. ESD can change the electrical characteristics of a semiconductor device - degrading or destroying it. ESD may also disturb the normal operation of an electronic system, such as a telecommunications device, causing equipment malfunction or failure. A current trend in microelectronic packaging is to pack more circuitry onto miniature devices, thereby increasing their sensitivity to ESD. The problems with ESD may for example arise when different materials get into contact with each other during the manufacturing process.

From prior art it is known to cover a single semiconductor chip by means of a can in order to protect the chip. For example US-A-6 118 177 discloses a heat spreader covering an IC device. According to this arrangement the heat spreader is directly connected to the IC substrate. The heat spreader is further shaped in the form of a table with a plurality of legs (i.e. open at the sides) and further connected to the IC device through a thermal interface material. Although this arrangement facilitates heat dissipation it cannot provide electrical shielding of the IC device at the same time. A further disadvantage with this arrangement is that it does not protect the IC device sufficiently from the surrounding environment. Since there are openings between the plurality of legs there will always be a risk with this arrangement that dust or any other particles get into contact with the IC chip, possibly causing damages to the final product.

Another prior art document, US 6 362 530, describes a flip chip integrated circuit covered by a metal cap, through which heat is dissipated via an applied "thermal grease". In one embodiment, the metal cap is directly soldered to a printed circuit board, thus providing e.g. better RFI (Radio Frequency Interference) protection of the single chip. However, according to this arrangement there are several contacts between the IC package and the PCB, the contacts being located outside the metal cap. Hence, there is no ESD protection inherent in the construction. A further disadvantage with this arrangement is that the package must be flipped over so as to enable attachment of the cap onto the PCB. This makes the assembly cumbersome. As a consequence the manufacturing costs may rise. Still a further consequence of a cumbersome assembly is that the components may, to a greater extent, be exposed to particles from the surrounding environment during manufacturing, thus possibly harming the final device.

A further prior art document, US-A-5 552 635, describes several different embodiments of a semiconductor chip covered by a metal cap. The cap covers the single chip and its associated heat spreading means so as to protect the IC chip. According to this arrangement the heat spreading means is either a heat spreading device mounted directly onto the IC chip or a heat spreading medium placed in between the IC chip and the metal cap. It should be emphasized that the cap itself does not act as the main heat dissipater according to this arrangement. If necessary it is possible to mount a heat sink on the metal cap in order to further improve the heat dissipation. This arrangement makes use of several components, which may complicate the assembly. In turn, this may lead to increasing manufacturing costs. Moreover, US-A 5 552 635 only describes a method of dissipating heat away from one single semiconductor chip.

### SUMMARY OF THE INVENTION

An object of the present invention is to provide an IC package arrangement for combined heat dissipation and RFI protection. A further object of the invention is to improve the protection of the module against ESD.

These objects are achieved by an IC package arrangement for combined heat dissipation and electrical shielding of a chip in an electronic apparatus. The arrangement comprises at least one IC chip mounted on a module substrate for arrangement on a PCB and a cover attachable to the at least one IC chip by means of a gap filler. The at least one IC chip and the module substrate are further covered by the cover.

Another object of the invention is to provide a method of assembling an IC package arrangement including a module, wherein at least one IC chip is mounted on a module substrate, a cover is either attached or attachable to the at least one IC chip by means of a gap filler, and the module substrate is either mountable or mounted on a PCB. The method further comprises the step of covering the at least one IC chip and the module substrate by means of the cover.

The arrangement and method according to the present invention provide several advantages. It provides the IC device with combined cooling and good electrical shielding at the same time. By electrically shielding the module, the radiation of unwanted signals from the module will thus be limited. By covering the module by means of the cover the module itself is also, inherently by the construction, protected against potential ESD problems. In addition, the cover takes little space. This in turn makes the assembly less costly since little material is used. Furthermore, the size of the final product may be reduced. Finally, as the assembly is facilitated the risk of exposing the IC components to surrounding particles is reduced during the manufacturing process, thus in turn limiting the potential problem with ESD.

It should be emphasized that the term "comprises/comprising", when used in this specification is taken to specify the presence of stated features, integers, steps or components but does not preclude the presence or addition of one or more other features, integers, steps or components or groups thereof.

### BRIEF DESCRIPTION OF THE DRAWINGS

In the following the invention will be described in further detail in connection with preferred embodiments and with reference to the accompanying drawings, in which
FIG 1 is a perspective view of a first embodiment of an IC package arrangement according to the invention,
FIG 2A illustrates wirebonding, which is a common principle for electrically connecting an IC chip to a substrate,
FIG 2B illustrates flip-chip bonding, yet another common bonding principle for electrically connecting an IC chip to a substrate,
FIG 3A, 3B, and 3C illustrate alternative embodiments of the IC package arrangement according to the invention,
FIG 4 is a perspective view illustrating a second embodiment of an IC package arrangement according to the invention,
FIG 5A shows two different orientations of an etched slit,
FIG 5B is a side view of one orientation of the etched slit in FIG 5A,
FIG 6 shows the steps according to a first assembly method according to the invention,
FIG 7 shows the steps according to a second assembly method according to the invention.

### DETAILED DESCRIPTION OF THE INVENTION

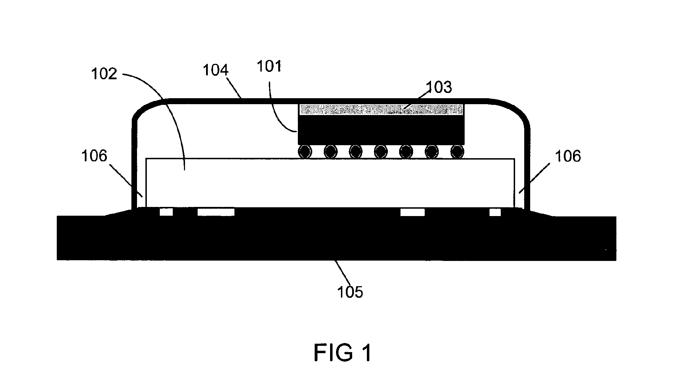

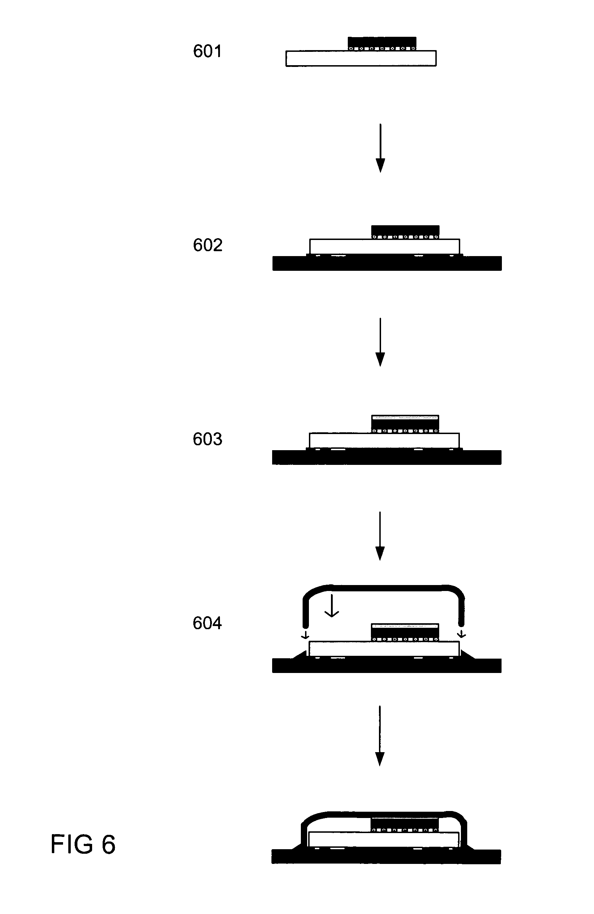

FIG 1 illustrates one preferred embodiment of the invention, i.e. an IC package arrangement comprising a power amplifying module (PA-module) used in electronic apparatuses. The term electronic apparatus includes portable radio communications apparatuses and the term portable radio communications apparatus in turn includes all apparatuses such as mobile telephones, pagers, communicators, i.e. electronic organizers, smartphones or the like. In the following the invention will be described with reference to this embodiment. The integrated circuit package arrangement shown in FIG 1 includes a PA-module, which comprises at least one semiconductor chip 101 mounted onto a module substrate 102, preferably by flip-chip bonding, as discussed later in connection with Fig 6. Initially the chip 101 is attached to a cover 104 by means of a thermally conductive gap filler 103. The gap filler 103 compensates tolerances in the substrate 102 and the cover 104. The intermediate gap filler 103 could for example be made of a thermally conductive silicone based material, a thermally conductive grease or a thermally conductive adhesive. One important feature with the invention is that the whole module, i.e. the at least one IC chip 101 and the module substrate 102, is covered. This is achieved by means of the cover 104, which forms the basis of the invention.

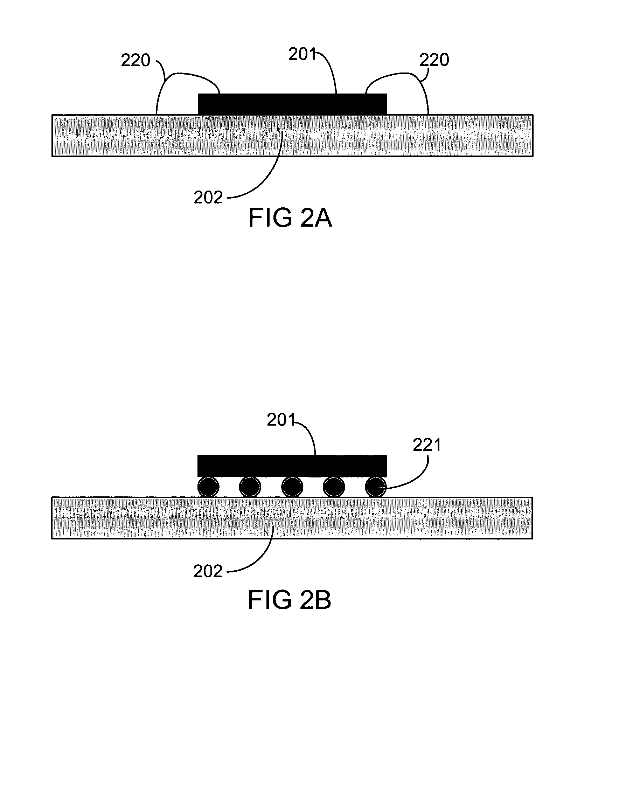

FIG 2 illustrates two common principles of attaching the at least one IC chip (201) to a substrate (202), i.e. Level 1 packaging. FIG 2A illustrates wirebonding, a method in which the semiconductor chip 201 is electrically connected to a substrate 202 by wires 220. This method is, although automated, rather time-consuming since each wire must be attached individually. FIG 2B illustrates another packaging method at Level 1, in which the IC chip 201 is attached to the substrate 202 by a plurality of solder bumps 221. This method is called flip-chip bonding. Flip-chip bonding is a direct interconnection technology in which the IC chip 201 is mounted upside-down onto a module substrate 202. The substrate 202 being e.g. an organic material, a copper-foil based laminate material or a ceramic material. Electrical connections are made via the solder bumps 221 or via solderless materials, such as epoxies or conductive adhesives located over the lower surface of the chip 201. In flip-chip bonding, the chips 201 are placed on the module substrate 202, so that the I/O pads on the chips 201 are aligned with those on the substrate 202. A solder reflow process is then used to simultaneously form all the required connections, thereby drastically improving throughput as compared with wirebonding. In the following description of the present invention it should be understood that the PA modules according to the invention are preferably assembled by flip-chip bonding or any similar direct interconnection packaging approach at Level 1.

Concerning the microelectronic packaging at Level 2 any conventional packaging method, e.g. surface mount packages, such as BGAs (Ball-Grid-Arrays), could be used in combination with the arrangement and method according to the present invention. It should be understood that the PCB 105 functions mainly as a mechanical support, an electrical insulation for metal interconnections, and a thermal conduction path. Numerous substrate materials exist for PCBs. For example, the PCB 105 may be provided in Epoxy-kevlar, Polimide-Quartz, Glass-epoxy (FR-4) or any other conventional material that is suitable as PCB material. Also different kinds of laminates, e.g. copper-foil based laminates, ceramics (e.g. HTCC, LTCC, or TFM), or deposited substrates, where metal and/or dielectric layers are deposited on metal, ceramic, or silicon substrates, could be used in the PCB 105.

When the module is assembled onto the PCB 105 the cover 104 is preferably simultaneously attached to the PCB 105 by means of soldering. It is important that the cover 104 is attached directly to the PCB 105 with no metal contact between the module substrate 102 and the cover 104 except through the PCB 105. This is further achieved by having an isolating means 106 between the cover 104 and the module substrate 102. The isolating means can for example be air or any other isolating medium or material. Since the cover 104 is grounded to the PCB 105 it acts as an electrical shield. In addition, it provides a good heat conduction path, thus transferring heat away from the module.

The cover 104 according to the invention is preferably made of a metal or a metal alloy, that is suitable for etching or drawing and cutting while at the same time has high thermal and electrical conductivity. As long as any metal or metal alloy is used, the electrical conductivity is sufficiently good for the purpose of the present invention. However, some metal or metal alloys are not appropriate as they provide a too low thermal conductivity. From a mechanical, manufacturing and thermal point of view pure copper, preferably cold rolled copper, copper alloys, e.g. bronze, brass, Cu with 0,5-1%Fe or Cu with 0,1-0,2%Zr, iron, steel or alloys of nickel and iron or nickel and copper are preferably used. As copper has a thermal conductivity of about 400 W/m **•** °C and the above mentioned alloys have thermal conductivities ranging from about 100 W/m **•** °C and up to almost 400 W/m• °C, it is to be understood that high thermal conductivity should be interpreted as all materials being in the range of 100-400 W/m **•** °C. In other words, the cover material should preferably not have a thermal conductivity of less than ¼ of that of copper.

The metal sheet, from which the cover 104 is formed, is preferably larger than the flip chip mounted component 101 and the diagonal length of the sheet should preferably be not more than 100 times the thickness of the sheet. Further, the metal sheet should preferably have a thickness ranging from 0.1-0.2 mm according to the present embodiment of the invention. It should however be understood that there is no absolute limit regarding the thickness.

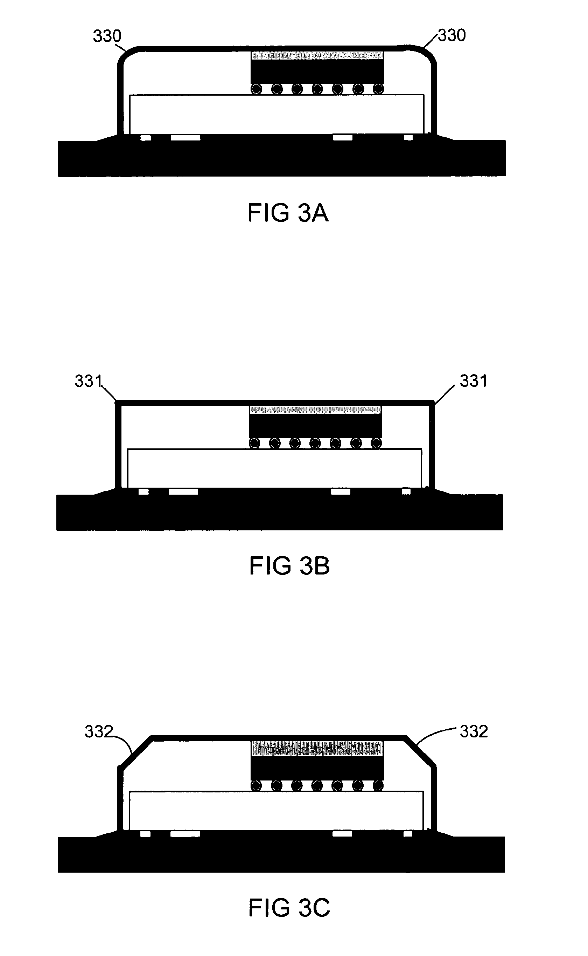

FIG 3 illustrates three alternative embodiments of the cover 104. FIG 3A illustrates a cover having rounded corners 330, while FIG 3B illustrates a cover with perpendicular corners 331. Finally, in FIG 3C the cover has sloping corners 332. Various changes and modifications of these embodiments may be suggested to one ordinary skilled in the art.

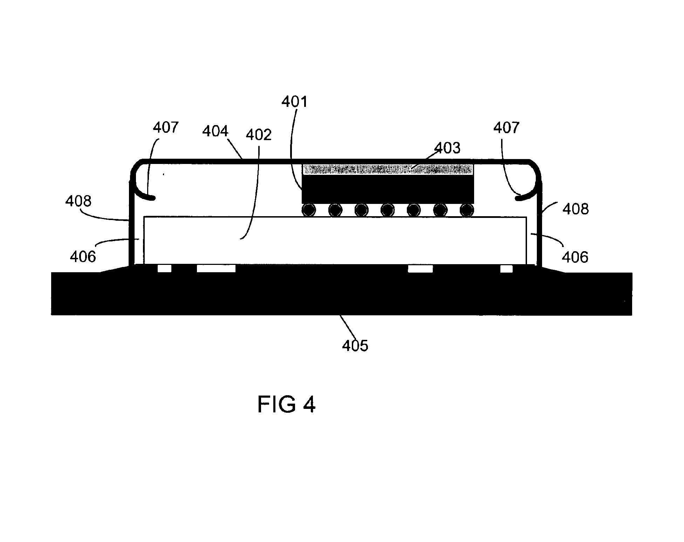

FIG 4 illustrates a second embodiment of the IC package arrangement in accordance with the present invention. The integrated circuit package arrangement shown in FIG 4 includes a PA-module, which comprises at least one semiconductor chip 401 mounted onto a module substrate 402. Initially the chip 401 is attached to a cover 404 by means of a thermally conductive gap filler 403. The IC chip 401 and the module substrate 402, are covered by means of the cover 404 and further attached to the PCB 405, thus providing a heat conduction path together with an electrical shield. In order to strongly support the module substrate 402 during e.g. testing the cover 404 further comprises one or a few tabs 407 facing inwards, the tabs being placed on at least one of the sides 408 of the cover 104.

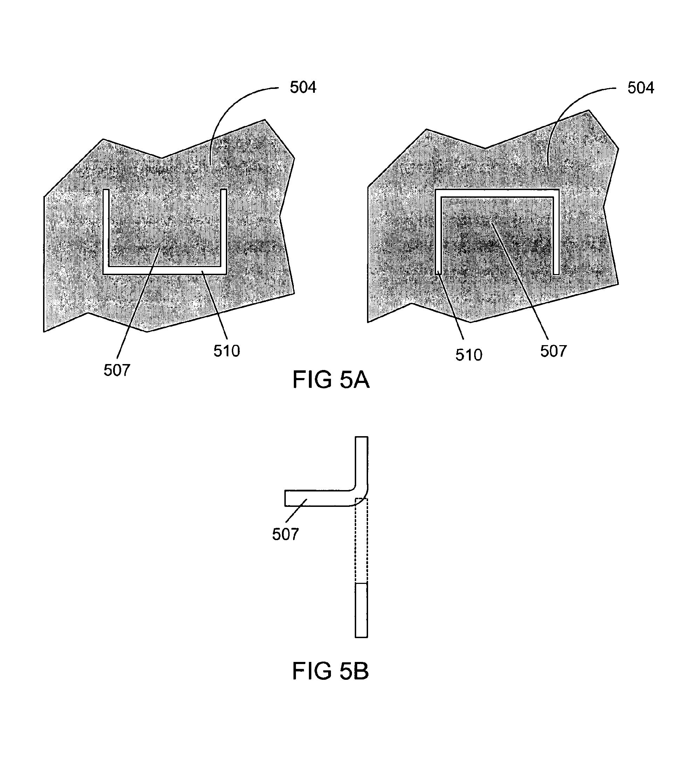

FIG 5 shows one preferred way of making a tab 407. The at least one tab 407 shown in FIG 4 is preferably made by etching a narrow slit 510 around at least three sides of the at least one intended tab 407, 507. When the etched sheet is folded into this shape, tabs 407, 507 are easily formed by pressing or bending the intended tabs 407, 507 inwards with regards to the cover 504 (see FIG 5B). Turning back to FIG 4, it is illustrated that the cover 404 may rest against the substrate by means of one or a few tabs 407. Consequently, the at least one IC chip and the module substrate are further protected, for example against excessive pressure during for instance testing, handling or mounting. It is further to be understood that there are several other ways of making the at least one tab 407.

FIG 6 shows one first embodiment of an assembly method according to the invention. In the following this method will be described, by way of example, with reference to PA-modules used in mobile phones and terminals. In step 601 of the assembly process one or a few IC chips is mounted on a module substrate. In the next step 602, the module substrate is further mounted onto the PCB and thereafter, in step 603, a gap filler material is added onto the upper surface of the IC chip. In the final step 604, a cover is attached to the PCB and it thus covers the IC chip as well as the module substrate.

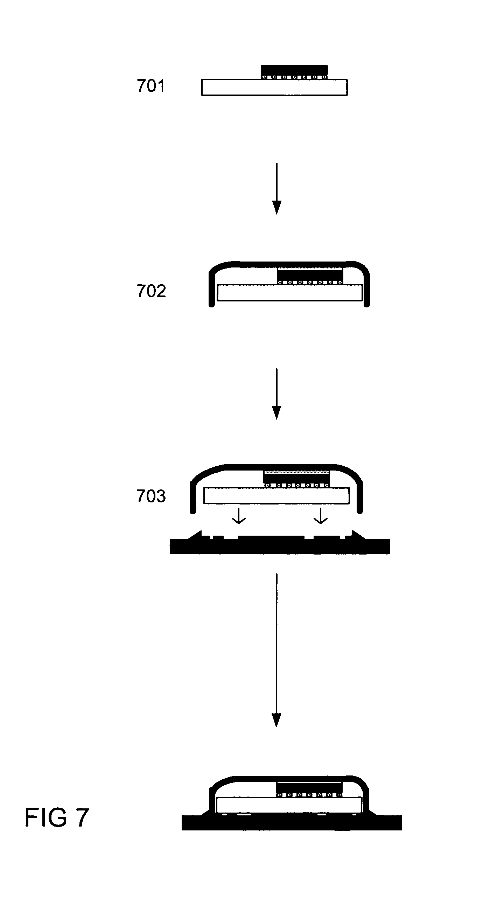

FIG 7 illustrates yet another preferred embodiment of an assembly method according to the invention. In the first step 701 of the assembly process, one or a few IC chips is mounted on a module substrate, so as to form a PA-module. In the second step 702, the at least one IC chip is attached to the cover by means of an intermediate gap filler, and thereby the at least one IC chip and the module substrate are covered by the cover. In the final step 703, the PA-module - with its associated cover - is mounted onto the PCB.

Although the IC package arrangement and method according to the present invention has been described with respect to specific preferred embodiments thereof, various changes and modifications may be suggested by one skilled in the art, and it is intended that the present invention encompass such changes and modifications as fall within the scope of the appended claims. In other words, the invention is not limited to the previously described examples. For instance, the cover mentioned in the specification may very well be a can or a cap. The can or the cap may in turn be made of a metal or any other material having high thermal conductivity and high electrical conductivity. Furthermore, the invention has been described with reference to PA-modules used in mobile phones and terminals. It should however be understood that the present invention could be applied to any module in any other electronic application where there is a need for heat dissipation and/or electrical shielding. Further possible applications, in which the present invention could be used, are for example hand held devices such as Personal Digital Assistants (PDA) or the like. Also home media systems or entertainment equipment such as Playstation 2® or GameBoy® are possible applications.

## Claims

1. An integrated circuit package arrangement suitable for combined heat dissipation and electrical shielding of a chip in an electronic apparatus, wherein the arrangement comprises at least one IC chip (101) mounted on a module substrate (102) for arrangement on a printed circuit board (105), and a cover (104) attachable to the at least one IC chip (101) by means of an intermediate gap filler (103), **characterized in that**
the at least one IC chip (101) and the module substrate (102) are covered by the cover (104).

2. An arrangement according to claim 1, **characterized in that** the module substrate (102) is mounted on the printed circuit board (105).

3. An arrangement according to claim 1, **characterized in that** the cover (104) is attached to the at least one IC chip (101) by means of the gap filler (103).

4. An arrangement according to any of the claims 1-3, **characterized in that** the cover (104) is directly attached to the printed circuit board (105) by soldering means for electrical connection to the ground plane of the printed circuit board (105).

5. An arrangement according to any of the claims 1-4, **characterized in that** the cover (104) covers the at least one IC chip (101) and the module substrate (102) by further having an isolating means (106) between the cover (104) and the module substrate (102).

6. An arrangement according to claim 5, **characterized in that** the isolating means (106) is air or any other isolating medium or material.

7. An arrangement according to any of the claims 1-6, **characterized in that** the cover (104) is made of a metal or metal alloy having high thermal conductivity and electrical conductivity.

8. An arrangement according to claim 7, **characterized in that** the cover (104) is made of copper or iron.

9. An arrangement according to claim 7, **characterized in that** the cover (104) is made of bronze, brass or steel.

10. An arrangement according to claim 7, **characterized in that** the cover (104) is made of a copper alloy with either 0,5-1% Fe or with 0,1-0,2% Zr.

11. An arrangement according to claim 7, **characterized in that** the cover (104) is made of alloys of nickel and iron or nickel and copper.

12. An arrangement according to any of the claims 7-11, **characterized in that** the cover (104) is made from a piece of metal sheet or a sheet made of a metal alloy having a thickness of 0.1-0.2 mm.

13. An arrangement according to any of the claims 1-12, **characterized in that** the cover (104) has tabs (407) facing inwards, the tabs being placed on at least one of the sides (408) of the cover (104).

14. An arrangement according to claim 13, **characterized in that** the cover (104) rests against the module substrate (402) by means of the tabs (407).

15. An arrangement according to any of the preceeding claims, **characterized in that** the IC chip (101) is mounted onto the module substrate (102) by flip chip bonding or any other interconnection technology.

16. An arrangement according to any of the preceeding claims, **characterized in that** the intermediate gap filler (103) is a silicone based thermally conductive gap filler, a thermally conductive adhesive or a thermally conductive grease.

17. A method of assembling an integrated circuit package arrangement including a module, wherein at least one IC chip (101) is mounted on a module substrate (102), a cover (104) is attached to the at least one IC chip (101) by means of an intermediate gap filler (103), and the module substrate (102) is mountable on a printed circuit board (105), **characterized by** the further step of covering the at least one IC chip (101) and the module substrate (102) by means of the cover (104).

18. A method according to claim 17, **characterized by** the further step of attaching the cover (104) to the printed circuit board (105) simultaneously as the mounting of the module substrate (102) onto the printed circuit board (105).

19. A method according to claim 18, **characterized in that** the cover (104) is directly attached to the printed circuit board (105) by soldering means for electrically connecting it to the ground plane of the printed circuit board (105).

20. A method according to claim 19, **characterized in that** the covering of the at least one IC chip (101) and the module substrate (102) is further achieved by having an isolating means (106) between the cover (104) and the module substrate (102).

21. A method according to claim 20, **characterized in that** the isolating means (106) is air or any other isolating medium or material.

22. A method of assembling an integrated circuit package arrangement including a module, wherein at least one IC chip (101) is mounted on a module substrate (102), a cover (104) is attachable to the at least one IC chip (101) by means of an intermediate gap filler (103), and the module substrate (102) is mounted on a printed circuit board (105), **characterized by** the further step of covering the at least one IC chip (101) and the module substrate (102) by means of the cover (104).

23. A method according to claim 22, **characterized by** the further step of attaching the cover (104) to the at least one IC chip (101) simultaneously as the attaching of the cover (104) to the printed circuit board (105).

24. A method according to claim 23, **characterized in that** the cover (104) is directly attached to the printed circuit board (105) by soldering means for electrically connecting it to the ground plane of the printed circuit board (105).

25. A method according to claim 24, **characterized in that** the covering of the at least one IC chip (101) and the module substrate (102) is further achieved by having an isolating means (106) between the cover (104) and the module substrate (102).

26. A method according to claim 25, **characterized in that** the isolating means (106) is air or any other isolating medium or material.

27. A method according to any of the claims 17-26, **characterized by** the further step of etching at least one slit around at least three sides of at least one intended tab (507), the intended at least one tab (507) being placed on the cover (104).

28. A method according to claim 27, **characterized by** the further step of pressing or bending-in the at least one intended tab (507) inwards, so as to form at least one tab (407) .
